(19) Europäisches Patentamt
European Patent Office
Office européen des brevets

(11) **EP 2 757 579 B1**

## (12) EUROPEAN PATENT SPECIFICATION

(45) Date of publication and mention
of the grant of the patent:
**19.06.2019 Bulletin 2019/25**

(51) Int Cl.:
***H01L 21/66*** *(2006.01)*        *G01R 31/26* *(2014.01)*

(21) Application number: **13151644.5**

(22) Date of filing: **17.01.2013**

(54) **Method for characterisation of shallow junctions for use in semiconductor devices**

Verfahren zur Charakterisierung von flachen Dotiergebieten für die Verwendung in Halbleiterbauelementen

Procédé de caractérisation de jonctions peu profondes destinées à être utilisées dans des dispositifs à semi-conducteurs

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**23.07.2014 Bulletin 2014/30**

(73) Proprietor: **IMEC VZW**
**3001 Leuven (BE)**

(72) Inventor: **Everaert, Jean-Luc**
**3001 Leuven (BE)**

(74) Representative: **AWA Sweden AB**
**P.O. Box 1066**
**251 10 Helsingborg (SE)**

(56) References cited:
**EP-A1- 1 998 184        US-A- 4 638 341**
**US-B1- 7 521 946**

- **STEVEN M BAIER ET AL: "FET Characterization Using Gated-TLM Structure", IEEE TRANSACTIONS ON ELECTRON DEVICES, IEEE SERVICE CENTER, PISACATAWAY, NJ, US, vol. ED-32, no. 12, December 1985 (1985-12), pages 2824-2829, XP001292553, ISSN: 0018-9383**
- **MICHAEL CURRENT ET AL: "Dopant Activation and Leakage Current Aspects of SDE/Halo CMOS Junctions Measured with Non-contact Junction Photo-Voltage Methods", JUNCTION TECHNOLOGY, 2007 INTERNATIONAL WORKSHOP ON, IEEE, PI, June 2007 (2007-06), pages 43-46, XP031120215, ISBN: 978-1-4244-1103-0**

## Description

## Technical field

The present disclosure relates to the field of characterisation of shallow junctions for use in semiconductor devices.

## Background art

For the fabrication of shallow junctions for use in semiconductor devices such as for instance transistors, the activation anneal, which is typically applied after dopant implantation in a substrate, has often severe thermal budget limitations. As a consequence typically not all implanted dopants are activated.

For process development of shallow junctions or passivation layers it is important and/or advantageous to know electrical characteristics of the junction.

A straightforward method known in the art is the use of the so-called "four point probe" that measures the sheet resistance ($R_s$) of the upper junction layer, possibly in combination with secondary ion mass spectroscopy (SIMS), which then allows to determine the active concentration and dose. However the use of the "four point probe" method and SIMS relies on theoretical mobility values of the free carriers in the upper layer of interest. As the sheet resistance depends on the active dose and the average mobility of the free charge carriers in the layer of interest, the upper layer, measuring this mobility is important. This can be done by Hall measurements, but these are not straight forward and require special attention when contacting the sample. It is not an in-line metrology method and no mapping capabilities are possible.

There exists no quick in-line metrology that can directly measure the active dose and average mobility of the free charge carriers in a shallow junction in-line.

Thus, there exists a need for an in-line metrology method for determining active dose and the average mobility of the free charge carriers in-line, to gain more scientific insight in the activation process.

Steven M Baier et al.: "FET Characterization Using Gated-TLM Structure", IEEE Transactions on Electron Devices, vol. ED-32, no. 12, December 1985, pages 2824-2829, discloses a FET characterization structure consisting of parallel ohmic contacts with gates of varying lengths in between. The low field electron mobility beneath the gate is determined as an effective uniform value and as a function of distance into the channel without iteration.

EP 1998184 A1 discloses a method of determination of the quality of the interface surface between a layer of a dielectric material and the top surface of the semiconductor substrate comprising the steps of: providing a semiconductor substrate with a top surface whereon a layer of a dielectric material is deposited thereby forming an interface surface, the surface of said layer of the dielectric material being or not in direct contact with the semiconductor substrate defining a top surface; applying a charge through discharge means on a dedicated area of said top surface; measuring a voltage Vs on said top surface; applying illumination means to said dedicated area, defining an illuminated spot; and measuring during the illumination of said area the photovoltage inside and outside said determined illuminated spot by means of measuring means.

## Summary of the disclosure

It is an aim of the present disclosure to provide a method for characterization of shallow junctions for use in semiconductor devices in-line (i.e. during process flow). Characterisation may for instance be based on performing local measurements, and may include representing the measurements in a map format.

A further aim of the present invention is to provide a method able to measure active dose and the average mobility of the free charge carriers directly and automatically.

A further aim is to provide a method which can be used for selecting manufacturing processes and for manufacturing process optimization of shallow junctions, as well as for quality control in manufacturing.

A further aim of the present invention is to avoid the high cost of characterisation by means of SIMS measurements as used in the prior art.

These aims are achieved according to the disclosure with a method showing the technical characteristics of the first independent claim.

According to a first aspect of the present invention, a method is disclosed in accordance with claim 1.

This provides the advantage that in-line metrology can be performed, whereby active dose and the average mobility of the free charge carriers is determined directly and automatically. The dopant activation process in the shallow junction can thereby closely be monitored and analyzed.

The substrate can be for instance a silicon, germanium or GaAs substrate. It can be any state of the art semiconductor substrate known to the skilled person on which a shallow junction is applied on a main surface.

The predetermined area may comprise the full first main surface of the substrate.

The shallow junction can be formed by ion implantation processes known to the skilled person. The junction has a thickness (or depth in another view) smaller than 50 nm, and preferably smaller than any value of 40, 30, 20, and 10 nm.

Providing and determining a value of a respective positive or negative charge on a predetermined area of the dielectric layer may embody a series of stepwise processes in which charges are added/removed for each iteration. The amount of removed or added charges between two iterations can for instance be substantially constant.

The dielectric layer may be any state of the art dielectric layer known to be suitable to the skilled person. It may for instance be a $SiO_2$ layer, which can for instance be deposited by a Plasma Enhanced CVD process (CVD). The thickness of the dielectric layer is within the range of 10 to 100nm.

According to preferred embodiments, the method further comprises removing or neutralizing the deposited charges from the predetermined area of the dielectric layer, after the series of iterations has ended (i.e. after iterating a combination of the iterated steps). Removing or neutralizing charges from the predetermined area of the dielectric layer can also be performed before starting the series of iterations (i.e. before iterating a combination of the iterated steps), if necessary.

This provides the advantage that the method may be repeated under the same initial conditions. According to certain embodiments, possibly an initial corona charge deposition can be provided to compensate initial existing charge in the dielectric or charge contained in or at the interface traps. When the process is to be repeated under the same initial conditions, e.g. in order to estimate or reduce the systematic error of the method, the initial corona charge deposition can be repeated also.

According to preferred embodiments, deriving at least one of a measure of an average hole/electron mobility or a measure of a dose of active dopants for the predetermined area comprises performing a linear fit.

According to preferred embodiments, the linear fit is based on the relation $1/R_s = \mu_p \cdot (q \cdot D_p - Q_c)$ for $p^+/n$-Si and $1/R_s = \mu_n \cdot (q \cdot D_n + Q_c)$ for $n^+/p$-Si junctions, wherein $Q_c$ is the respective charge deposited on the dielectric layer, $R_s$ is the sheet resistance of the upper junction layer, $D_p/D_n$ is the authentic dose of holes/electrons before providing any charges, $\mu_p$ and $\mu_n$ are the average hole /electron mobility in the respective $p^+/ n^+$ layer of the shallow junction, and q is the unit of electrical charge.

According to preferred embodiments, the dielectric layer and the first main surface are in direct contact. The dielectric layer can be deposited on the first main surface.

According to preferred embodiments, the respective charges are provided by corona charging.

According to preferred embodiments, the shallow junction is a junction of the $p^+n$ type.

According to preferred embodiments, the shallow junction is a junction of the $n^+p$ type.

According to preferred embodiments, the respective charges are positive. They can for instance comprise positively charged ions.

According to preferred embodiments, the respective charges are negative. They can for instance comprise negatively charged ion.

In second aspect of the present invention, a method is disclosed for mapping characteristic information for a shallow junction on a substrate, comprising performing a method according to any of the embodiments of the first aspect, on at least two predetermined and disjoint areas.

According to preferred embodiments, the method for mapping is being performed on a plurality of predetermined disjoint areas, and the union of the predetermined disjoint areas corresponds to the first main surface of the substrate.

## Brief description of the drawings

The disclosure will be further elucidated by means of the following description and the appended figures.

Figure 1 shows a typical setup for performing the method according to any of the embodiments of the present invention.
Figure 2 illustrates an embodiment of a step which is part of the method according to the present invention, based on a linear fitting of the measured data.
Figure 3 is a table providing an overview of results obtained from the data shown in Figure 2.
Figure 4 illustrates a mobility map of a shallow junction measured with a method according to aspects of the present invention.
Figure 5 illustrates an active dose map of a shallow junction measured with a method according to aspects of the present invention.

## Detailed description of preferred embodiments

The present disclosure will be described with respect to particular embodiments and with reference to certain drawings but the disclosure is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Moreover, the terms top, bottom, over, under and the like in the description are used for descriptive purposes and not necessarily for describing relative positions. The terms so used are interchangeable under appropriate circumstances and the embodiments of the disclosure described herein can operate in other orientations than described or illustrated herein.

Furthermore, the various embodiments, although referred to as "preferred" are to be construed as exemplary manners in which the disclosure may be implemented rather than as limiting the scope of the disclosure.

The term "comprising", used in the claims, should not be interpreted as being restricted to the elements or steps listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising A and B" should not be limited to devices consisting only of components A and B, rather with respect to the present disclosure, the only enumerated components of the device are A and B.

In order to illustrate aspects of the present invention, a metrology tool of the Semilab WT-2000 type has been used, which comprises capabilities of corona charging and Junction Photo Voltage measurement (JPV). The functioning of this device is considered to known to the skilled person, and some relative aspects of its functioning has been described for instance in European Patent EP1998184 B1.

The method comprises the combination of at least two measurement modules or devices, more specifically the combination of a first module able to apply a corona charge on a specific area on said interface surface and measuring the related surface voltage (referred to as Q-V module) and of a second module (referred to as the junction photovoltage module or JPV module), applying a laser or LED pulse at a fixed frequency leading to an illuminated spot within said specific area and subsequently measuring the induced photovoltage (V1) inside and (V2) outside respectively the illumination spot by means of two electrodes.

The two electrodes measuring the voltages are preferably concentric or at least partly concentric. Alternatively the electrodes can be linear (in case the laser or LED spot is a concentric spot). The mobility is then derived from the sheet resistance (sheet resistance is inversely proportional to the mobility), that itself derives from the induced photovoltage (V1) and (V2) measured respectively inside and outside the illumination spot.

By illuminated spot, it should be understood a small area defined by receiving a certain amount of energy from a laser or LED.

By corona charge it should be understood as creating ionized molecules by corona discharge effect (by applying high voltage between a sharply curved electrode and the ground exceeding the Corona Inception Voltage of the charger assembly).

The method comprises the step of applying a charge, preferably a corona charge, on the dielectric layer to attract or repulse free charge carriers in the $p^+$ or $n^+$ top layer of the pn junction. The value of charge applied is then measured, preferably by measuring the corresponding surface potential contactless using a Kelvin probe through a Q-V module, to check whether any corona charge leaked away. Then a measurement performed with the JPV module is used to determine the sheet resistance of the $p^+$ or $n^+$ layer of the shallow junction.

The step of applying a corona charge is preferably performed over the entire substrate (wafer) by passing a metallic (e.g. tungsten) wire at a fixed potential (e.g. 10 kV) over the substrate surface. Alternatively and also preferred the Q-V corona charge is deposited locally by using a corona jet. In said corona jet, airflow blows out ions generated in an assembly consisting of a sharp needle centered in a tube which blows corona charge on the substrate surface locally on a (approximately 1cm$^2$) predetermined area. The related surface voltage Vs (at least on said specific area) is preferably measured contactless using a Kelvin probe.

A Kelvin probe can be defined as a vibrating electrode ($\sim$0.5cm$^2$ area) positioned over the surface forming a capacitor. If the voltage applied to the electrode is equal to the surface voltage, the AC current flow has its minimum providing a way to measure the surface voltage in a non-contact way (the specific Kelvin probe was manufactured by Trek, Inc.).

The step of measuring the sheet resistance of the free charge carriers in the $p^+$ or $n^+$ layer under the dielectric layer is performed using the JPV module. The JPV module is preferably used with a laser or LED pulse that creates electron-hole pairs in the underlying (e.g. Si or Ge) substrate. By applying a laser or LED pulse at a fixed frequency, an illuminated spot is created under the inner electrode, while the outer electrode remains in the dark region. Using an appropriate wavelength for the LED or laser light (e.g.470nm in case for Si), electron hole pairs are created in the illuminated region. On a p+n-type shallow junction , the internal electric field of the junction will move an excess amount of holes into the $p^+$ layer near the interface surface of the dielectric layer and the (Si) substrate. Due to the charge gradient an electric field parallel to the interface surface will spread out the excess charges radially in parallel to the interface surface.

By using two at least partly concentric electrodes whereby one electrode (R1) is situated within the illuminated spot and one electrode (R2) is situated outside the illuminated spot, the induced photovoltage V1 (originating from R1) and V2 (originating from R2) can be derived. The at least partly concentric electrodes can have a ring structure. The voltages V1 and V2 respectively are measured preferably contactless by the electrodes R1 and R2 respectively.

Alternatively and also preferably, the electrodes can for instance be linear electrodes e.g. finger shaped electrodes.

The measurement of the voltages V1 and V2 originating from the at least partly concentric electrodes can be performed in a contactless manner by capacitive coupling.

The method which combines JPV measurements with corona voltage deposition can be applied on different wafer sites such that a sheet resistance mapping system is created. This new mapping method makes it possible to characterize the shallow junction on a substrate (e.g. Si wafer).

According to preferred embodiments of the invention, the process of applying a corona charge is applied over the entire surface of the substrate by passing a metallic (e.g. tungsten) wire over the wafer, the wire is at a fixed voltage e.g. 10kV.

By passing, it can be suggested a constant speed linear movement according to X and Y directions, obviously any other movement considered suitable to the skilled person can also be used. The speed of the displacement of the means creating the corona charge (a metallic wire or corona jet) will lead to the formation of the corona charges having a charge density.

The speed determines the charge deposition and the speed can preferably vary between 0.01 and 20 cm/s.

Alternatively, although less preferred because of current practical limitations, the step of applying a corona is applied locally on a dedicated area by using a corona jet, which blows corona charge on the wafer surface locally on an about 2 cm$^2$ area.

According to preferred embodiments of the invention, the step of measuring the surface voltage Vs at least locally on a dedicated area is performed using a Kelvin probe. Preferably the measurement is performed contactless.

According to preferred embodiments of the invention, the step of creating an excess amount of free charges in the shallow junction (holes for p$^+$-type silicon, electrons for n$^+$-type silicon) at least locally on a dedicated area onto the substrate is performed using a laser or LED pulse which creates electron hole pairs in the substrate underneath the at least one dielectric layer such that an excess amount of the free charges is created locally in the upper layer of the shallow junction near the interface formed by the surface dielectric layer and semiconductor.

According to preferred embodiments of the invention, the step of measuring the photovoltage inside and outside the illuminated spot by means of two at least partly concentric electrodes is performed using the Junction Photo Voltage module. The basis of the JPV measurement is to use photo excitation of charge carriers and to monitor in a spatially resolved manner the JPV signals inside and outside the illumination spot.

According to preferred embodiments of the invention, the substrate is a flat substrate such as e.g. a silicon (Si) or germanium (Ge) wafer. The substrate can also be a SOI (Silicon-On-Insulator) or a GOI (Germanium-On-Insulator) substrate which is basically a silicon (germanium) wafer with a thin layer of oxide (e.g. SiO2) buried on it as dielectric layer. The substrate can be cleaned prior to the step of depositing a dielectric layer to remove contaminants. Preferably the substrate can be doped and annealed to obtain e.g. a p$^+$n-doped or n$^+$p-shallow junction substrate.

According to another preferred embodiment of the invention, the at least one dielectric layer is a single dielectric layer or a combination of dielectric layers (for example a "dual dielectricum"). Preferred examples of dielectric materials used as for dielectric layers are materials such as SiO$_2$ layers, SiN, SiON, HfO$_2$ or other metallic/rare-earth oxides such as ZrO$_2$, Al$_2$O$_3$, La$_2$O$_3$, Pr$_2$O$_3$, Ta$_2$O$_5$,... and also the related silicates of these metals/rare-earth elements. The thickness of the dielectric layer is within the range of 10 to 100nm.

According to preferred embodiments of the invention, the process of depositing at least one dielectric layer is performed using deposition techniques such as for instance Chemical Vapor Deposition (CVD), Plasma Enhanced CVD (PECVD), Metal Organic Chemical Vapor Deposition (MOCVD), Atomic Layer Deposition (ALD).

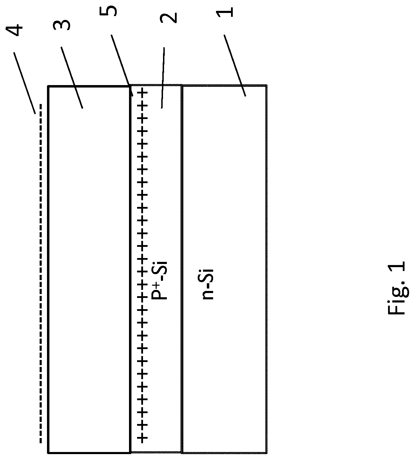

Figure 1 illustrates a method according to a preferred embodiment of the present invention. An n-type silicon substrate 1 is provided. After shallow junction formation by ion implantation, defining a p$^+$n junction 2 at or in a front surface of the substrate, an electrical insulating dielectric 3 is deposited. Here, a CVD oxide with a thickness of 50 nm is deposited at 400 °C. A shallow p$^+$n junction is used, made by B-implant in n-type silicon at 0.2keV.

A series of corona charge depositions 4 was performed, each followed by a junction photovoltage (JPV) measurement. This type of measurement is further denoted as CJPV. The JPV delivers the sheet resistance R$_s$ of the p$^+$ layer below the dielectric layer, the oxide (Fig.1). The oxide prevents that any corona charge leaks away. It influences the amount of free carriers in the p$^+$ layer by induction. A positive corona charge will repulse the holes in the p$^+$ layer resulting in a higher R$_s$. A negative corona charge will attract an equal amount of positively charged holes 5, decreasing the Rs. 1/Rs can be expressed as :

$$1/R_s = \mu.(q.D_p - Q_c)$$

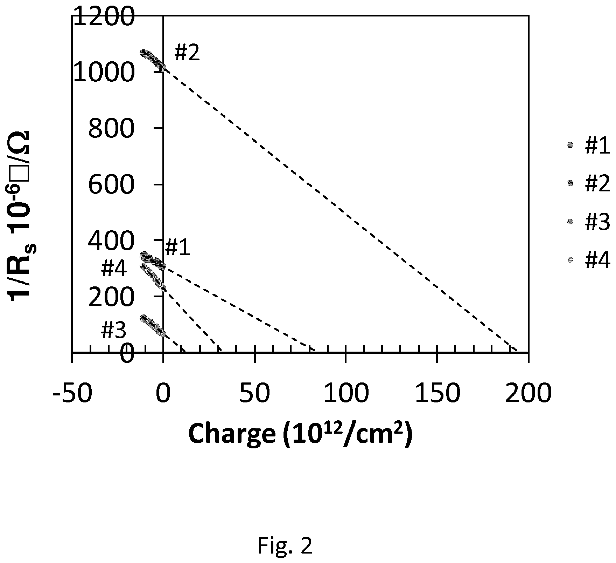

in which $\mu$ is the average hole mobility in the p$^+$ layer, D$_p$ is the original (before corona charging) dose of holes and q is the unit charge. D$_p$ is to good approximation equal to the dose of active boron dopants. Q$_C$ is the corona charge deposited on the oxide which can be positive as well as negative. A linear relationship exists between 1/R$_s$ and Q$_C$ for which the slope represents the average hole mobility while the x-axis intersection represents qD$_p$. So if an amount of corona charge Qc equal to qD$_p$ could be deposited, then no conductance would be detected anymore. In practice this is not possible as the amount of corona charge would be so high that the corona charge would leak away by tunneling or oxide break down. This means an extrapolation from the data points is needed as shown in Fig.2. Similarly this technique can be applied on n$^+$p, for instance comprising arsenic or phosphor implanted in p-type Silicon substrate. Also junctions on other substrates as for instance Ge and GaAs substrates can be measured this way.

Figure 2 depict as graph illustrating different results #1, #2, #3, #4 of a CJPV measurement on a p$^+$n junction, wherein the slope of the fitted line corresponds or is related to the hole mobility in the shallow junction, while the x-axis intersection corresponds or is related to the active dose in the shallow junction.

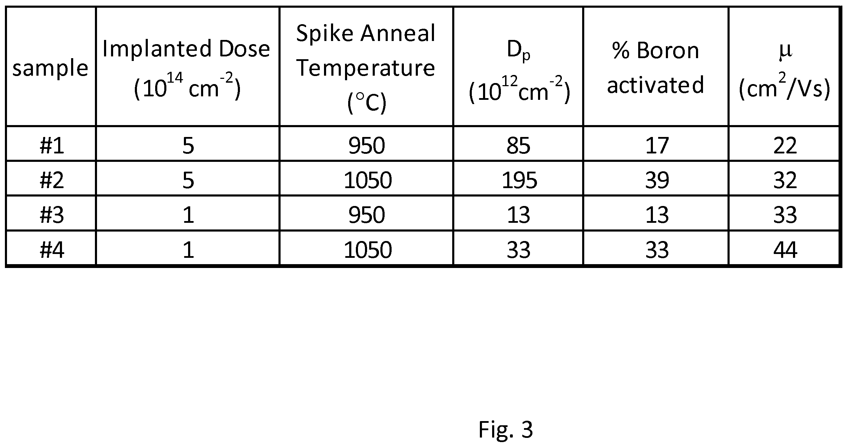

The table of Figure 3 shows the results for #1, #2, #3, #4 obtained with the CJPV method. It clearly shows higher activation for higher anneal temperature. The obtained mobility values are realistic and in agreement with literature (e.g. F. Severac et. al., Mater. Sci. Eng. B, 154-155 (2008), p. 225-228), for similar process conditions.

It will be appreciated that this combination of corona charge and JPV can be implemented as a fully automated, fast, in-line metrology. The automatization also allows mapping capability.

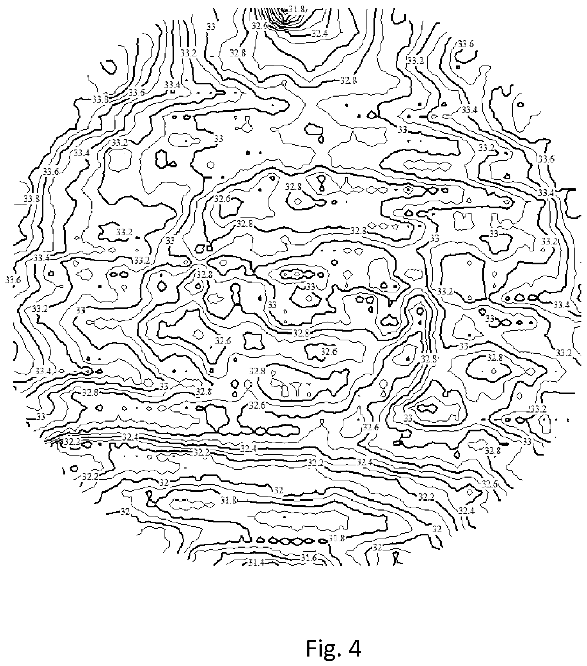

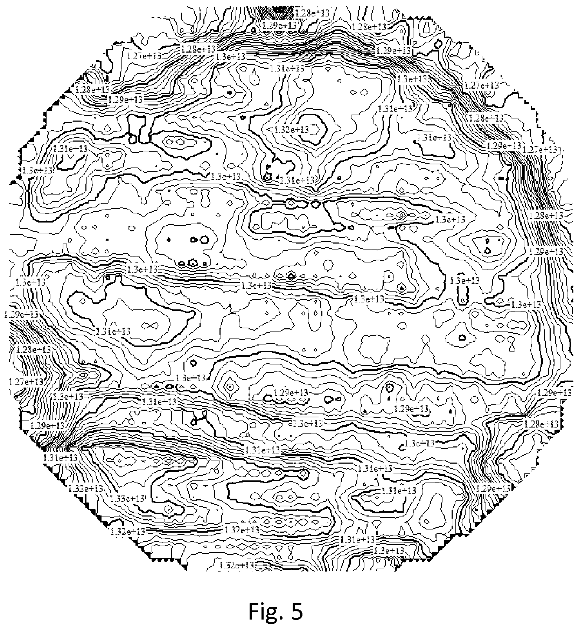

Fig. 4 and Fig. 5 illustrate maps derived with methods according to the present disclosure, based on a silicon substrate which was exposed to a 0.2keV, B 1E14cm-2 doping level and a spike anneal at 950°C to produce a shallow junction. The map resolution for this example was 4x4 mm$^2$. The above described calculation was applied to obtain $\mu$ and $D_p$ for each pixel of the map. A contour map was calculated therefrom. Fig. 4 depicts a Mobility map (in cm$^2$/Vs). Fig. 5 depicts an Active dose map (cm$^{-2}$).

## Claims

1. Method for characterisation of shallow junctions for use in semiconductor devices, the method comprising:

   a. providing a substrate (1) comprising a shallow junction (2) at a first main surface of said substrate (1), said shallow junction (2) being formed substantially parallel to said first main surface, wherein said shallow junction (2) has a depth smaller than 50 nm;
   b. providing a dielectric layer (3) on top of said first main surface, wherein said dielectric layer (3) has a thickness within the range of 10 to 100 nm;
   c. defining a predetermined area of said dielectric layer (3) and of the underlying substrate (1), and iterating a combination of the following iterated steps for at least two times:

   - providing and determining a value of a respective charge (4) on said predetermined area of said dielectric layer (3) by means of a discharge means;
   - measuring a corresponding junction photovoltage for said predetermined area;

   d. deriving at least one of a measure of an average hole/electron mobility or a measure of a dose of active dopants for said predetermined area of said substrate (1), from said respective charges (4) and said corresponding junction photo voltages.

2. Method according to claim 1, further comprising removing or neutralizing the deposited charges (4) from the predetermined area of the dielectric layer (3), before iterating a combination of said iterated steps.

3. Method according to claim 1 or 2, wherein said deriving at least one of a measure of an average hole/electron mobility or a measure of a dose of active dopants for said predetermined area comprises performing a linear fit.

4. Method according to claim 3, wherein said linear fit is based on the relation $1/R_s=\mu_p.(q.D_p-Q_c)$ or $1/R_s=\mu_n.(q.D_n+Q_c)$, wherein $Q_c$ is the respective charge (4) deposited on said dielectric layer (3), $R_s$ is the sheet resistance of a $p_+$ or $n_+$ upper layer of the shallow junction (2), $D_p$ / $D_n$ is the original dose of holes/electrons before providing any charges, $\mu_p/\mu_n$ is the average hole/electron mobility in the $p^+$ / $n^+$ upper layer of the shallow junction (2), and q is the unit of electrical charge.

5. Method according to any of the previous claims, wherein said dielectric layer (3) and said first main surface are in direct contact.

6. Method according to any of the previous claims, wherein said respective charges (4) are provided by corona charging.

7. A method according to any of the previous claims, wherein said shallow junction (2) is a junction of the $p^+n$ type.

8. A method according to any of claims 1 to 6, wherein said shallow junction (2) is a junction of the $n^+p$ type.

9. A method according to any of the previous claims, wherein said respective charges (4) are positive.

10. A method according to any of claims 1 to 8, wherein said respective charges (4) are negative.

11. Method for mapping characteristic information for a shallow junction (2) on a substrate (1), comprising performing a method according to any of claims 1 to 10 on at least two predetermined and disjoint areas.

12. Method according to claim 11, being performed on a plurality of predetermined disjoint areas, wherein the union of said predetermined disjoint areas corresponds to said first main surface of said substrate (1).

## Patentansprüche

1. Verfahren zur Charakterisierung von flachen Dotiergebieten zur Verwendung in Halbleitervorrichtungen, das Verfahren Folgendes umfassend:

   a. Bereitstellen eines Substrats (1), umfassend ein flaches Dotiergebiet (2) an einer ersten Hauptoberfläche des Substrats (1), wobei das flache Dotiergebiet (2) im Wesentlichen parallel zu der ersten Hauptoberfläche ausgebildet ist, wobei das flache Dotiergebiet (2) eine Tiefe kleiner als 50 nm aufweist;
   b. Bereitstellen einer dielektrischen Schicht (3) oben auf der ersten Hauptoberfläche, wobei die dielektrische Schicht (3) eine Dicke innerhalb des Bereichs von 10 bis 100 nm aufweist;
   c. Definieren einer vorgegebenen Fläche der dielektrischen Schicht (3) und des unterliegenden Substrats (1) und Iterieren einer Kombination der folgenden iterierten Schritte mindestens zwei Mal:

   - Bereitstellen und Bestimmen eines Werts einer jeweiligen Ladung (4) auf der vorgegebenen Fläche der dielektrischen Schicht (3) mittels eines Entlademittels;
   - Messen einer entsprechenden Dotiergebiet-Photospannung für die vorgegebene Fläche;

   d. Ableiten mindestens eines Maßes einer durchschnittlichen Löcher-/Elektronenbeweglichkeit und/oder eines Maßes einer Dosis aktiver Dotierungsstoffe für die vorgegebene Fläche des Substrats (1) aus den jeweiligen Ladungen (4) und den entsprechenden Dotiergebiet-Photospannungen.

2. Verfahren nach Anspruch 1, weiterhin umfassend Entfernen oder Neutralisieren der abgeschiedenen Ladungen (4) aus der vorgegebenen Fläche der dielektrischen Schicht (3) vor Iterieren einer Kombination der iterierten Schritte.

3. Verfahren nach Anspruch 1 oder 2, wobei das Ableiten mindestens eines Maßes einer durchschnittlichen Löcher-/Elektronenbeweglichkeit und/oder eines Maßes einer Dosis aktiver Dotierungsstoffe für die vorgegebene Fläche Durchführen einer linearen Anpassung umfasst.

4. Verfahren nach Anspruch 3, wobei die lineare Anpassung auf der Beziehung $1/R_s=\mu_p.(q.D_p-Q_c)$ oder $1/R_s=\mu_n.(q.D_n+Q_c)$ basiert, wobei Qc die jeweilige Ladung (4) ist, welche auf der dielektrischen Schicht (3) abgeschieden wurde, $R_s$ der Flächenwiderstand einer oberen $p^+$- oder $n^+$-Schicht des flachen Dotier-

gebiets (2) ist, $D_p/D_n$ die ursprüngliche Dosis von Löchern/Elektronen vor Bereitstellen von Ladungen ist, $\mu_p/\mu_n$ die durchschnittliche Löcher-/Elektronenbeweglichkeit in der oberen $p^+$- oder $n^+$-Schicht des flachen Dotiergebiets (2) ist und q die Einheit der elektrischen Ladung ist.

5. Verfahren nach einem der vorhergehenden Ansprüche, wobei die dielektrische Schicht (3) und die erste Hauptoberfläche in unmittelbarem Kontakt stehen.

6. Verfahren nach einem der vorhergehenden Ansprüche, wobei die jeweiligen Ladungen (4) durch Koronaaufladung bereitgestellt sind.

7. Verfahren nach einem der vorhergehenden Ansprüche, wobei das flache Dotiergebiet (2) ein Dotiergebiet vom Typ $p^+$n ist.

8. Verfahren nach einem der Ansprüche 1 bis 6, wobei das flache Dotiergebiet (2) ein Dotiergebiet vom Typ $n^+$p ist.

9. Verfahren nach einem der vorhergehenden Ansprüche, wobei die jeweiligen Ladungen (4) positiv sind.

10. Verfahren nach einem der Ansprüche 1 bis 8, wobei die jeweiligen Ladungen (4) negativ sind.

11. Verfahren zum Abbilden von charakteristischen Informationen für ein flaches Dotiergebiet (2) auf einem Substrat (1), umfassend Durchführen eines Verfahrens nach einem der Ansprüche 1 bis 10 auf mindestens zwei vorgegebenen und nicht zusammenhängenden Flächen.

12. Verfahren nach Anspruch 11, welches auf mehreren vorgegebenen nicht zusammenhängenden Flächen durchgeführt wird, wobei die Vereinigung der vorgegebenen nicht zusammenhängenden Flächen der ersten Hauptoberfläche des Substrats (1) entspricht.

## Revendications

1. Procédé de caractérisation de jonctions peu profondes destinées à être utilisées dans des dispositifs à semi-conducteurs, le procédé comprenant :

   a. la fourniture d'un substrat (1) comprenant une jonction peu profonde (2) sur une première surface principale dudit substrat (1), ladite jonction peu profonde (2) étant formée de manière substantiellement parallèle à ladite première surface principale, dans lequel ladite jonction peu profonde (2) présente une profondeur inférieure à 50 nm ;
   b. la fourniture d'une couche diélectrique (3) sur ladite première surface principale, dans lequel ladite couche diélectrique (3) présente une épaisseur comprise dans une plage de 10 à 100 nm ;

c. la définition d'une zone prédéterminée de ladite couche diélectrique (3) et du substrat sous-jacent (1), et l'itération d'une combinaison des étapes itérées suivantes au moins deux fois :

- fourniture et détermination de la valeur d'une charge respective (4) sur ladite zone prédéterminée de ladite couche diélectrique (3) à l'aide d'un moyen de décharge ;
- mesure d'une phototension de jonction correspondante pour ladite zone prédéterminée ;

d. la dérivation d'au moins une valeur parmi la mesure d'une mobilité électron/trou moyenne et la mesure d'une dose de dopants actifs pour ladite zone prédéterminée dudit substrat (1), pour lesdites charges respectives (4) et lesdites phototensions de jonction correspondantes.

2. Procédé selon la revendication 1, comprenant en outre l'élimination ou la neutralisation des charges déposées (4) de la zone prédéterminée de la couche diélectrique (3), avant l'itération d'une combinaison desdites étapes itérées.

3. Procédé selon la revendication 1 ou 2, dans lequel ladite dérivation d'au moins une valeur parmi la mesure d'une mobilité électron/trou moyenne et la mesure d'une dose de dopants actifs pour ladite zone prédéterminée comprend la mise en oeuvre d'une régression linéaire.

4. Procédé selon la revendication 3, dans lequel ladite régression linéaire est basée sur la relation $1/R_s=\mu_p.(q.D_p-Q_c)$ ou $1/R_s=\mu_n.(q.D_n+Q_c)$, dans lequel $Q_c$ est la charge respective (4) déposée sur ladite couche diélectrique (3), $R_s$ est la résistance de feuille d'une couche supérieure p+ ou n+ de la jonction peu profonde (2), $D_p / D_n$ est la dose originale d'électrons/trous avant de fournir une quelconque charge, $\mu_p/\mu_n$ est la mobilité électron/trou moyenne dans la couche supérieure $p^+ / n^+$ de la jonction peu profonde (2), et q est l'unité de charge électrique.

5. Procédé selon l'une quelconque des revendications précédentes, dans lequel ladite couche diélectrique (3) et ladite première surface principale sont en contact direct.

6. Procédé selon l'une quelconque des revendications précédentes, dans lequel lesdites charges respectives (4) sont fournies par effet corona.

7. Procédé selon l'une quelconque des revendications précédentes, dans lequel ladite jonction peu profonde (2) est une jonction de type $p^+n$.

8. Procédé selon l'une quelconque des revendications 1 à 6, dans lequel ladite jonction peu profonde (2) est une jonction de type $n^+p$.

9. Procédé selon l'une quelconque des revendications précédentes, dans lequel lesdites charges respectives (4) sont positives.

10. Procédé selon l'une quelconque des revendications 1 à 8, dans lequel lesdites charges respectives (4) sont négatives.

11. Procédé de mappage d'information caractéristique pour une jonction peu profonde (2) sur un substrat (1), comprenant la mise en oeuvre d'un procédé selon l'une quelconque des revendications 1 à 10 sur au moins deux zones disjointes et prédéterminées.

12. Procédé selon la revendication 11, mis en oeuvre sur une pluralité de zones disjointes prédéterminées, dans lequel l'union desdites zones disjointes prédéterminées correspond à ladite première surface principale dudit substrat (1).

Fig. 1

Fig. 2

| sample | Implanted Dose $(10^{14}\,cm^{-2})$ | Spike Anneal Temperature (°C) | $D_p$ $(10^{12}\,cm^{-2})$ | % Boron activated | $\mu$ $(cm^2/Vs)$ |
|---|---|---|---|---|---|
| #1 | 5 | 950 | 85 | 17 | 22 |
| #2 | 5 | 1050 | 195 | 39 | 32 |
| #3 | 1 | 950 | 13 | 13 | 33 |
| #4 | 1 | 1050 | 33 | 33 | 44 |

Fig. 3

EP 2 757 579 B1

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1998184 A1

- EP 1998184 B1

**Non-patent literature cited in the description**

- **STEVEN M BAIER et al.** FET Characterization Using Gated-TLM Structure. *IEEE Transactions on Electron Devices,* December 1985, vol. ED-32 (12), 2824-2829

- **F. SEVERAC.** *Mater. Sci. Eng. B,* 2008, 225-228